# EUROPÄISCHE PATENTSCHRIFT

(11) **EP 3 050 131 B1**
(45) Veröffentlichungstag und Bekanntmachung des Hinweises auf die Patenterteilung: **14.02.2018**
(21) Anmeldenummer: 14752313.8
(22) Anmeldetag: 14.08.2014
(51) Int. Cl.: H01L 35/34

(54) **VERBESSERTES VERFAHREN ZUR PULVERMETALLURGISCHEN HERSTELLUNG THERMOELEKTRISCHER BAUELEMENTE**
IMPROVED METHOD FOR PRODUCING THERMOELECTRIC COMPONENTS BY POWDER METALLURGY
PROCÉDÉ AMÉLIORÉ DE FABRICATION DE COMPOSANTS THERMOÉLECTRIQUES PAR MÉTALLURGIE DES POUDRES

(30) Priorität: 27.09.2013 DE 102013219541
(43) Veröffentlichungstag der Anmeldung: 03.08.2016
(73) Patentinhaber: Evonik Degussa GmbH, 45128 Essen (DE)
(72) Erfinder: BUSSE, Jens, 44879 Bochum (DE); HOCH, Sascha, 44797 Bochum (DE); KERN, Magdalena, 63755 Alzenau (DE); GIESSELER, Mareike, 63477 Maintal (DE); SCHULTZ, Thorsten, 64739 Hassenroth (DE); STENNER, Patrik, 63452 Hanau (DE); MORTENSEN, Paw V., DK-9800 Hjørring (DK); ENKESHAFI, Ali Asghar, DK-9200 Aalborg (DK)
(86) Internationale Anmeldenummer: PCT/EP2014/067387
(87) Internationale Veröffentlichungsnummer: WO 2015/043824

(56) Entgegenhaltungen:
- US-A- 3 201 504
- US-A- 3 269 871
- US-A- 6 025 554
- US-A- 6 127 619
- US-B1- 6 297 441

## Beschreibung

Die Erfindung betrifft ein Verfahren zur Herstellung eines thermoelektrischen Bauelements oder zumindest eines Halbzeugs desselben, bei welchem in ein im Wesentlichen ebenes Substrat aus einem elektrisch und thermisch isolierenden Substratmaterial eine Vielzahl von Thermoschenkeln aus thermoelektrisch aktivem Aktivmaterial dergestalt eingebracht wird, dass sich die Thermoschenkel im Wesentlichen senkrecht zur Substratebene durch das Substrat hindurch erstrecken, und bei welchem das Aktivmaterial pulverförmig bereitgestellt, zu Grünlingen verpresst und anschließend innerhalb des Substrats zu Thermoschenkeln versintert wird.

Ein thermoelektrisches Bauelement ist ein Energiewandler, welcher thermische Energie unter Ausnutzung des von Peltier und Seebeck beschriebenen thermoelektrischen Effekts in elektrische Energie umsetzt. Da der thermoelektrische Effekt reversibel ist, kann jedes thermoelektrisches Bauelement auch zur Umsetzung von elektrischer Energie in thermische Energie genutzt werden: so genannte Peltier-Elemente dienen unter elektrischer Leistungsaufnahme zum Kühlen bzw. Wärmen von Objekten. Peltier-Elemente verstehen sich daher auch als thermoelektrische Bauelemente im Sinne der Erfindung. Thermoelektrische Bauelemente, die zur Umwandlung von thermischer Energie in elektrische Energie dienen, werden oft als thermoelektrische Generatoren (TEG) bezeichnet.

Beispiele und Einführungen zu thermoelektrischen Bauelementen finden sich unter:
- Thermoelectrics Handbook - Macro to nano, D. M. Rowe (ed.), CRC - Taylor & Francis Group, Boca Raton, London, New York, 2006, ISBN 978-0-8493-2264-8
- Thermoelectrics Goes Automotive, D. Jänsch (ed.), expert verlag GmbH, 2011, ISBN 978-3-8169-3064-8;
- JP2006032850A;
- EP0773592A2;
- US6872879B1;
- US20050112872A1;
- JP2004265988A.

Technisch ausgeführte thermoelektrische Bauelemente umfassen mindestens ein aus zwei Thermoschenkeln gebildetes Thermopaar aus thermoelektrisch aktivem Material und eine das Thermopaar tragende und umschließende, elektrisch nach außen hin isolierende Hülle.

Im Stand der Technik ist eine Vielzahl von thermoelektrisch aktiven Materialien beschrieben. Für den kommerziellen Einsatz eignen sich beispielsweise Legierungen aus der Klasse der halbleitenden Wismuthtelluride (insbesondere mit zusätzlichen Anteilen von Selen und/oder Antimon) aus welchen sich - einerseits p-leitend und andererseits n-leitend dotiert - ein Thermopaar aufbauen lässt.

Weitere thermoelektrisch aktive Stoffklassen sind: Halb-Heusler-Materialien, verschiedene Silizide (insbesondere Magnesium, Eisen), verschiedene Telluride (Blei, Zinn, Lanthan, Antimon, Silber), verschiedene Antimonide (Zink,Cer, Eisen, Ytterbium, Mangan, Cobalt, Wismut; Teilweise auch als Zintl-Phasen bezeichnet), TAGS, Siliziumgermanide, Clathrate (insbes. auf Germanium-Basis). Neben diesen Halbleitermaterialien lassen sich thermoelektrische Bauelemente auch aus Kombinationen der meisten gewöhnlichen Metalle herstellen, wie dies z.B. bei handelsüblichen Thermoelementen zur Temperaturmessung der Fall ist, z.B. Ni-CrNi. Jedoch sind die so erzielbaren sog. Gütezahlen (thermoelektrische "Wirkungsgrade") deutlich geringer als bei den genannten Halbleitermaterialien.

Konventionelle thermoelektrische Bauelemente bestehen üblicherweise aus massiven Quadern aus thermoelektrisch aktiven Halbleitern sowie harten, zumeist keramischen, elektrisch isolierenden Umhüllungen. Soweit massive Quader eingesetzt werden, werden diese aus massiven Ingots herausgesägt. Des Weiteren ist es bekannt, thermoelektrisch aktives Material pulvermetallurgisch zu verarbeiten, um in einem Sinterschritt wieder möglichst dichte, hohlraumarme Blöcke zu erhalten, aus denen wiederum nach Bedarf quaderförmige TE-Schenkel herausgesägt werden.

Nach diesem Stand der Technik ist es bekannt, das pulverförmig vorliegende Aktivmaterial durch eine perforierte Matrize hindurchzupressen, so dass tablettenförmige Grünlinge anfallen. Die Matrize ist dabei ein festes Werkzeug der Tablettiervorrichtung. Die durch die Matrize gepressten, thermoelektrischen Grünlinge werden sodann gesintert, ggfs. nach Bedarf zugesägt, poliert und/oder beschichtet, unter Zuhilfenahme gelochter Raster geeignet angeordnet, miteinander über Lötbrücken elektrisch verbunden, das Raster wird wieder entfernt, verbleibende Kontaktbrücken werden aufgebracht, und das so erhaltene Halbzeug des thermoelektrischen Bauelements wird abschließend durch zwei Deckplatten, insbesondere aus Keramikwerkstoffen, und gegebenenfalls seitlichen Abschluss (z.B. durch Silikondichtungsmassen) zum einsatzfähigen Modul komplettiert.

Aus der WO2008061823A1 und US 6 297441 B1 ist es bekannt, ein Halbzeug für ein thermoelektrisches Bauelement herzustellen, indem in ein flächiges poröses Substrat thermoelektrisches Material als Pulver eingebracht wird. Die Thermoschenkel des hergestellten Bauelements erstrecken sich senkrecht zur Substratebene.

Ein Verfahren der eingangs genannten Gattung ist den Erfindern aus der zum Zeitpunkt der Anmeldung noch unveröffentlichten DE102012205087A1 bekannt. Die Verpressung des pulverförmig bereitgestellten Aktivmaterials erfolgt innerhalb der Löcher einer perforierten Matrize, die zu einem Bestandteil des hergestellten thermoelektrischen Bauelements wird, nämlich zum Substrat.

Der Nachteil dieses Verfahren ist darin zu sehen, dass diese Matrize notwendigerweise aus einem thermisch und elektrisch isolierenden Werkstoff bestehen muss, da sie als Substrat in dem TEG verbleibt. Zugleich muss die Matrize während des Pressens der Grünlinge hohe mechanische Belastungen ertragen, was die Wahl des thermisch und elektrisch isolierenden Substratmaterials einschränkt.

Ausgehend von diesem Stand der Technik liegt der Erfindung die Aufgabe zu Grunde, das Verfahren der eingangs genannten Gattung so weiterzubilden, dass die Freiheit zur Auswahl des thermisch und elektrisch isolierenden Substratmaterials erhöht wird.

Gelöst wird die Aufgabe dadurch, dass das pulverförmige Aktivmaterial in einer außerhalb des Substrats angeordneten Form zu Grünlingen verpresst wird, die Grünlinge aus der Form heraus in vorgesehene Löcher des Substrats eingedrückt und darin zu Thermoschenkeln versintert werden, wobei das Verpressen des pulverförmigen Aktivmaterials zu den Grünlingen und für das Eindrücken dieser Grünlinge in die Löcher des Substrats mit Hilfe derselben Werkzeuge erfolgen und wobei es sich bei den Werkzeugen um mindestens ein Paar beidseitig in die Form einfahrende Stempel handelt, von denen einer durch das für den jeweiligen Grünling im Substrat vorgesehene Loch hindurchgreift.

Gegenstand der Erfindung ist mithin ein Verfahren zur Herstellung eines thermoelektrischen Bauelements oder zumindest eines Halbzeugs desselben, bei welchem in ein im Wesentlichen ebenes Substrat aus einem elektrisch und thermisch isolierenden Substratmaterial eine Vielzahl von Thermoschenkeln aus thermoelektrischem Aktivmaterial dergestalt eingebracht wird, dass sich die Thermoschenkel im Wesentlichen senkrecht zur Substratebene durch das Substrat hindurch erstrecken, und bei welchem das Aktivmaterial pulverförmig bereitgestellt, zu Grünlingen verpresst und anschließend innerhalb des Substrats zu Thermoschenkeln versintert wird, wobei das pulverförmige Aktivmaterial in einer außerhalb des Substrats angeordneten Form zu Grünlingen verpresst wird, und bei welchem die Grünlinge aus der Form heraus in vorgesehene Löcher des Substrats eingedrückt und darin zu Thermoschenkeln versintert werden.

Der Erfindung liegt die Idee zu Grunde, das Pulver ex situ, nämlich in einer gesonderten Form außerhalb des Substrats, zu Grünlingen zu verpressen und die Grünlinge dann in dafür vorgesehene Löcher des Substrats einzudrücken.

Gegenüber der DE102012205087A1 praktizierten in situ Verpressung hat dieses Vorgehen den entscheidenden Vorteil, dass die Form innerhalb des späteren TEG keine Funktion mehr zu erfüllen hat und deswegen auch nicht aus einem isolierenden Material bestehen muss. So kann die Form einfachstenfalls aus Stahl sein, welcher hervorragend die beim Pressen der Grünlinge auftretenden Kräfte ertragen kann. Zugleich kann das Substrat aus einem thermisch und elektrisch isolierenden Material bestehen, welches nur eine vergleichsweise geringe mechanische Festigkeit aufweist, da beim Eindrücken der Grünlinge in das Substrat deutlich geringe Kräfte entstehen als beim Verpressen des Pulvers. Die Freiheit zur Auswahl des für die Funktionsweise des thermoelektrischen Bauelements optimalen Substratmaterials wird dadurch deutlich erweitert.

Das erfindungsgemäße Verfahren erschließt nicht nur Vorteile hinsichtlich des herzustellenden Produktes sondern ermöglicht auch verfahrenstechnische Vorteile:
Werkzeuge zum Pressen sind nämlich nicht nur dafür geeignet, Druck auf das Material auszuüben, sondern auch das Material zu bewegen. Durch die multifunktionelle Nutzung der Werkzeuge wird das Herstellungsverfahren rationeller. Die für die Verpressung des Aktivmaterials notwendige Presskraft ist etwa um den Faktor 10 bis 100 größer als die Kraft, die erforderlich ist, den Grünling in das Substrat einzupressen.

Eine solche Konstellation ist verfahrenstechnisch besonders einfach umzusetzen.

Eine weitere bevorzugte Ausführungsform des erfindungsgemäßen Verfahrens sieht vor, dass eine Mehrzahl von Formen zu einer ebenen Matrize zusammengefasst sind, und dass die Matrize zumindest während des Verpressens des Aktivmaterials und des Eindrückens der Grünlinge auf dem Substrat dergestalt flächig aufliegt, dass Löcher und Formen fluchten. Durch das Zusammenfassen mehrerer Formen zu einer Matrize lassen sich die Taktzeiten verringern, da mehrere Formen gleichzeitig mit Pulver gefüllt, darin Grünlinge verpresst und diese dann in das Substrat eingedrückt werden können. Das Verfahren wird dadurch deutlich schneller und rationeller. Die Formen werden dabei bevorzugt zu einer auf dem Substrat flächig aufliegenden, ebenen Matrize zusammengefasst, damit die Matrize das Substrat während des Eindrückens fixieren kann. Dazu später mehr. Um ein Durchgreifen des einen Stempels durch das Substrat hindurch in die Formen zu ermöglichen, sollen Löcher und Formen miteinander fluchten. Bevorzugt entspricht die Anzahl der zur Matrize zusammengefassten Formen der Anzahl der Löcher im Substrat. Mithin ist es möglich, in einem Arbeitsgang das gesamte Substrat aus der Matrize zu befüllen. Alternativ ist es möglich, eine geringere Anzahl von Formen z.B. zu einem Matrizenstreifen zusammenzufassen und das Substrat in mehreren Zügen mit Grünlingen zu befüllen.

Die Löcher im Substrat sind vorzugsweise kreiszylindrisch und als Durchgangsloch ausgeführt. Kreiszylindrische Durchgangslöcher lassen sich nämlich besonders einfach in das Substrat einbringen. Dementsprechend sollte die Form auch entsprechend kreiszylindrisch ausgeführt sein und zwar mit dem im Wesentlichen selben Durchmesser wie die Löcher, da der Grünling bereits recht nah am Maß des späteren Thermoschenkels verpresst wird. Die Form dient nämlich dann gleichzeitig zur Kalibrierung des Grünlings.

Vor dem Eindrücken der Grünlinge in das Substrat muss dieses mit geeigneten Löchern versehen werden, in welche die Grünlinge eingedrückt werden. Das Lochen erfolgt vorzugsweise mit einem spanenden Fertigungsverfahren, wie beispielsweise dem Bohren oder dem Fräsen. Als besonders vorteilhaft hat sich das Bohren erwiesen, da das Loch direkt auf Maß gebohrt werden kann. Falls die Genauigkeit des Bohrens oder die Oberflächenqualität der Bohrwandung nicht ausreicht, kann die Wandung auch ausgerieben werden. In jedem Fall empfiehlt es sich, trocken zu Bohren, d. h. ohne Zuhilfenahme von Kühlschmierstoffen. Dies ist kontraintuitiv, da das zu lochende Substratmaterial thermisch isolierend ist und deswegen nur eine geringe Wärmeabfuhr erlaubt, was die Zugabe von Kühlschmierstoffen nahe legt. Allerdings hat sich überraschend gezeigt, dass die Wandung des Substratmaterials ohne Verwendung eines Kühlschmierstoffes geringer beschädigt wird und dementsprechend der Grünling, und später der aus ihm erzeugte Thermoschenkel, besser in der für ihn vorgesehenen Bohrung fixiert bleibt.

Die Haftung und der Sitz des Grünlings bzw. des Thermoschenkels in dem Loch kann dadurch signifikant verbessert werden, dass die Löcher während und unmittelbar nach der spanenden Bearbeitung ausgeblasen werden um abgetragenes Material effektiv zu entfernen. Zum Ausblasen nutzt man jedoch nicht herkömmliche Druckluft sondern besser ein inertes Gas, welches weitestgehend frei ist von Sauerstoff, Kohlenstoffdioxid und Wasserdampf. Am besten eignet sich trockener Stickstoff zum Ausblasen der Löcher. Grund für die Verwendung von Inertgas ist die Empfindlichkeit vieler thermoelektrischer Aktivmaterialien gegenüber Oxidation.

Wichtig ist, dass das Substrat während des Einbringens der Löcher beidseitig von ebenen Spannmitteln gehalten wird und zwar zumindest im Bereich der einzubringenden Löcher, bestenfalls jedoch vollflächig. Der Grund dafür ist, dass viele Substratmaterialien, insbesondere solche, die als Laminat aufgebaut sind, beim Bohren splittern, einreißen oder delaminieren können. Dies ist unbedingt zu vermeiden, da andernfalls der Sitz der Schenkel im Substrat beeinträchtigt wird und sich etwaige Fissuren im Substrat fortsetzen und zu einem Bruch des thermoelektrischen Bauelements führen können. Wird das Substrat jedoch beidseitig von Spannmitteln gegriffen und mit einem geringen Druck beaufschlagt, so wird die Gefahr der Bildung von derartigen Beschädigungen deutlich verringert. Auch werden deutlich bessere Qualitäten der Oberflächen der Bohrungsflanken erzielt als ohne Einspannung.

Ein geeigneter Druck für die Beaufschlagung des Substrats mit den Spannmittel liegt im Bereich von 20kPa bis 100kPa.

Insbesondere dann wenn die Spannmittel vollflächig auf dem Substrat aufliegen ist es erforderlich, dass zumindest eines der beiden Spannmittel über Bohrungen verfügt, durch welche der Bohrer beim Bohren der Löcher hindurchgreift. Ein Aufbohren des Spannmittels mit Hilfe des Bohrers macht keinen Sinn. Auch kann das mit den Bohrungen versehene Spannmittel nach dem Einbringen der Löcher zugleich als Matrize genutzt werden. Der Prozess wird dadurch erheblich rationeller, da ein Umspannen entfällt.

Grundsätzlich eröffnet das erfindungsgemäße Verfahren die Möglichkeit, aus einer breiten Palette von möglichen Substratmaterialien zu wählen. Zur Steigerung der Effizienz des thermoelektrischen Generators sollte möglichst ein Substratmaterial gewählt werden, was in einem hohen Maße thermisch und elektrisch isoliert. Allerdings muss das Substratmaterial auch preisgünstig verfügbar sein, um die Wirtschaftlichkeit sicherzustellen. Weiterhin muss das Substratmaterial eine für den weiteren Fertigungsweg und die spätere Nutzung im thermoelektrischen Bauelement geeignete Temperaturbeständigkeit aufweisen. Als besonders wirtschaftliches Substratmaterial bieten sich Verbundwerkstoffe an, die aus anorganischen Rohstoffen und Bindemitteln aufgebaut sind. Bei den anorganischen Rohstoffen handelt es sich vorzugsweise um Glimmer, Perlite, Phlogopite, oder um Muscovite. Als Bindemittel wird vorzugsweise Silikon oder Silikonharz verwendet. Mit diesen Materialien lassen sich insbesondere als Schichtwerkstoff aufgebaute Substrate laminieren. Als Substrat bestens geeignet sind die unter dem Markennamen Miglasil® und Pamitherm® erhältlichen Isolationsplatten der Schweizer Firma von Roll AG. Es handelt sich dabei um Laminate, die aus Silikongebundenen Muscoviten aufgebaut sind. Dieses temperaturstabile Isolationsmaterial lässt sich hervorragend im erfindungsgemäßen Prozess verarbeiten, obwohl es mechanisch vergleichsweise fragil ist. Die laminierte Form ist insbesondere anfällig für Fissuren, die bei nicht erfindungsgemäßer Einbringung entstehen.

Bei der Verwendung von laminierten Substratmaterialien aus anorganischen Rohstoffen und Bindern ist die Einhaltung von geeigneten Maschinenparametern während der mechanischen Bearbeitung wichtig, um Beschädigungen des Materials zu vermeiden. So sollte beim spanenden Lochen von Pamitherm-Platten mit Vollhartmetallbohrern eine Schnittgeschwindigkeit im Bereich von 0,3m/s bis 1,5 m/s eingehalten werden. Bei einem Bohrerdurchmesser von 4 mm bedeutet dies Drehzahlen von ca. 1500 bis 7500/min. Der Vorschub sollte im Bereich von 50 bis 250 mm/min liegen. Es können ebenso auch spezielle für Laminate entwickelte Bohrer und Fräsbohrer verwendet werden.

Das Substrat wird als ebenes Material verwendet mit einer Stärke zwischen 1 und 10mm. Bevorzugt liegt die Stärke zwischen 1,5 und 4mm, ganz besonders bevorzugt zwischen 2 und 3mm. Pamitherm®-Platten werden in dieser Schichtstärke angeboten.

Für jedes Thermopaar sind je zwei unterschiedlich leitende thermoelektrische Aktivmaterialien notwendig, die elektrisch miteinander verbunden werden, wobei das erste Aktivmaterial z.B. p-leitend und das zweite Aktivmaterial n-leitend ist, oder umgekehrt. Unterschiedlich bedeutet hier, dass die beiden Aktivmaterien einen unterschiedlichen Seebeck-Koeffizienten aufweisen. P- und n-leitende Halbleiter sind als Aktivmaterialien besonders bevorzugt, da ihre Seebeck-Koeffizienten unterschiedliche Vorzeichen (negativ bei n-Leitern, positiv bei p-Leitern) aufweisen und daher der numerische Unterschied der Seebeck-Koeffizienten besonders groß ist. Dies erhöht die Effizienz des thermoelektrischen Bauelements.

Vorzugsweise werden nach dem erfindungsgemäßen Verfahren beide Aktivmaterialien gleichzeitig zu den jeweiligen Grünlingen verpresst.

Grundsätzlich ist jedwedes thermoelektrische Aktivmaterial erfindungsgemäß verwendbar, sofern es sich pulvermetallurgisch verarbeiten lässt. Dies sind insbesondere Legierungen aus der Klasse der Wismuthtelluride, Zinkantimonide, Silicide und Halb-Heusler-Materialien.

Die Partikelgrößenverteilung des Aktivmaterials ist für das Verpressen und den Sintervorgang von besonderer Bedeutung. Sie wird mittels Laserbeugungsverfahren bestimmt. Demnach beträgt die mittlere Partikelgröße d₅₀ des Aktivmaterials zwischen 1 und 50 µm. Zwar zeigt das Pulver bei dieser Partikelgröße fluidisches Verhalten bei Verdichtung und setzt die von den Stempeln während des Verpressens aufgebrachten Kräfte weitgehend in Querkräfte um, welche die Form belasten, dies ist aber bei der vorliegenden Erfindung nicht bedeutsam, da die Form aus einem stabilen Material wie Stahl bestehen kann, welches die Querkräfte erträgt.

Die mittlere Partikelgröße im Bereich zwischen 1 und 50 µm ist deswegen vorteilhaft, da die Vermahlung des Aktivmaterials auf diese Partikelgröße mit noch vergleichsweise geringem Energieeinsatz möglich ist: Je feiner das Material, desto energieaufwendiger ist seine Vermahlung. Hier hat sich gezeigt, dass zwischen 1 und 50 µm mittlerer Partikelgröße ein hervorragender Kompromiss zwischen Energiebedarf der Fertigung des Pulvers und der Qualität der gesinterten Schenkel erzielt wird. Der Energiebedarf des Mahlprozesses kann dadurch gesenkt werden, dass die Vermahlung bei einer maximalen Temperatur zwischen 30°C und 50 °C durchgeführt wird. Hierdurch wird zudem das Mahlgut weniger thermisch belastet, was den thermoelektrischen Gütezahlen zu Gute kommt.

Nachdem das pulverförmige Aktivmaterial in die Form eingefüllt ist, wird es vorzugsweise mit Vibration beaufschlagt. Dies geschieht einfachstenfalls durch Vibrationsanregung der Form, bei Frequenzen von 5 bis 50Hz und Auslenkungs-Amplituden von bis zu 0,1 mm über einen Zeitraum von 1 bis 5 Sekunden. Alternativ kann das Pulver über eine eintauchende Nadel (Durchmesser <1mm) mit Vibration beaufschlagt werden, wobei die Nadel mittig fluchtend mit der Bohrung eingetaucht werden sollte, bis eine Eintauchtiefe in das Pulver von mindestens 90% erreicht ist, die Frequenzen sollten bis zu 1000Hz betragen bei max. Nadelspitzenauslenkungen (ohne Pulverumgebung) von 0,5mm und einer Vibrationsdauer von 1 bis 5 Sekunden. Die Nadel muss dann bei noch laufender Vibration aus dem Pulver herausgezogen werden. Durch die Vibration setzt sich die Pulvermischung, sodass beim Verpressen keine plötzlichen Volumenänderungen auftreten, die mit einer Beschädigung des Grünlings einhergehen könnten.

Der Pressdruck zum Verpressen des pulverförmigen Aktivmaterials zu den Grünlingen hängt von dem gewählten Material und der Partikelgrößenverteilung ab. Wismuthtelluride mit einer mittleren Partikelgröße zwischen 1 und 50 µm werden bevorzugt mit einem Druck von 500 bis 5000 MPa zu Grünlingen verpresst, wobei sich eine mittlere Dichte der Grünlinge von mindestens 90% der Dichte des zugrunde liegenden Massivmaterials (Ingot) ergibt.

Nachdem die Grünlinge in das Substrat eingebracht sind, werden sie darin versintert. Dies erfolgt beispielsweise mittels Strom-Sinter-Methoden, d. h. vermittels Durchleitung von elektrischem Strom und daraus folgender Aufheizung des Gefüges des Aktivmaterials. Spark Plasma Sintering (SPS) ist dabei die bevorzugte Strom-Sinter-Methode, welche in der einschlägigen Literatur ausgiebig beschrieben ist. Beim Stromsintern kann das Stempelpaar, welches zum Eindrücken der Grünlinge in das Substrat verwendet wird, als Elektrodenpaar verwendet werden. Der Sintervorgang (d. h. der elektrische Stromfluss) kann so bereits während der Verdichtung in der Form einsetzen, was allerdings voraussetzt, dass die Form elektrisch nicht leitend ist. Aus diesem Grunde wird vorzugsweise innerhalb des elektrisch isolierenden Substrats gesintert. Sofern die Stempel zugleich als Elektroden verwendet werden, kann während des Sinterprozesses auch ein zusätzlicher Druck über die Stempel auf den Grünling angelegt werden, der allerdings geringer ist, als beim vorangehenden kalten Verpressen des Grünlings.

Bevorzugt wird allerdings nicht mit einer Strom-Sinter-Methode gearbeitet, sondern thermisch in einem konventionellen Ofenprozess:
Hierzu wird das Substrat mit eingebrachten Grünlingen zum Versintern in einen Autoklaven verbracht, in welchem der Sinterprozess bei erhöhtem Druck und erhöhter Temperatur in inerter Atmosphäre erfolgt. Unter einer inerten Atmosphäre ist in diesem Zusammenhang ein den Autoklaven ausfüllendes Gasgemisch zu verstehen, welches möglichst frei von Sauerstoff, Kohlenstoffdioxid, Wasserdampf und anderen oxidierenden Stoffen ist, da diese Stoffe, insbesondere unter höherer Temperatur und
Druck, das Aktivmaterial zu oxidieren drohen. Dies kann dadurch verhindert werden, dass als inerte Ofenatmosphäre Stickstoff oder Argon (Reinheit jeweils mindestens 4.0, besser jedoch 5.0) verwendet wird. Der von der Ofenatmosphäre auf das Werkstück ausgeübte hydrostatische Druck ist vorzugsweise so zu wählen, dass dieser geringer ist als der Druck, der beim kalten Pressen der Grünlinge auf das pulverförmige Aktivmaterial ausgeübt wurde. Diese Maßgabe ist dem Umstand geschuldet, dass andernfalls eine Beschädigung des Werkstückes, insbesondere des Substratmaterials, im Autoklaven zu befürchten ist.

Soll beispielsweise Wismuthtellurid in einem Pamitherm®-Substrat versintert werden, werden folgende Bedingungen im Autoklaven gewählt:
Stickstoff (Reinheit 5.0), Ofentemperatur 250-330°C, Maximaldruck 5-30 MPa, Haltezeit bei Maximaldruck 10s bis 10min.

Ein besonderer Vorteil des thermischen Sinterprozesses besteht darin, dass das thermoelektrische Bauteil geringeren mechanischen Belastungen ausgesetzt wird als bei den anderen Sintermethoden. Dies ist insbesondere bei der Verwendung von empfindlichen Substratmaterialien vorteilhaft. Weiterhin ist dieser thermische Sinterprozess auch ökonomisch vorteilhaft gegenüber Stromsinterprozessen. Dies beruht darauf, dass eine Vielzahl von mit Grünlingen ausgestatteten Substraten gleichzeitig dem Autoklavenprozess unterworfen werden können. Somit ist eine prozesstechnische Entkoppelung zum Pressprozess gegeben. Bei den meisten Stromsinterverfahren muss während des Sinterprozesses gleichzeitig ein mechanischer Druck auf die Sinterkörper ausgeübt werden. Dies bedingt dass der Sinterprozess noch innerhalb des eigentlichen Presswerkzeuges oder innerhalb eines ähnlichen nachgeschalteten Werkzeuges stattfinden muss. Derartige Sinterprozesse sind durch vergleichsweise lange Verweildauern, d.h. lange Taktzeiten, und damit geringe Durchsätze pro Sinterwerkzeug, gekennzeichnet, während der vorgeschaltete Pulvereinfüll- und Pressvorgang üblicherweise durch kurze Taktzeiten (im Bereich von Sekunden) gekennzeichnet ist. Gleichzeitig sind Werkzeuge zum Aufbringen von hohen Presskräften üblicherweise teuer und verursachen hohe laufende Energiekosten. Eine Versinterung in einem derartigen Presswerkzeug ist mithin aus ökonomischer Sicht nachteilig, da sie bei geringem Durchsatz hohe Investitions- und Betriebskosten verursacht.

Prozesstechnisch lässt sich der Sinterprozess am einfachsten als Batch-Prozess ausführen, währenddessen sich das Lochen und Verpressen als ein getaktet kontinuierlicher Prozess darstellen lässt. Zur Verknüpfung der beiden Prozessschritte ist es wie bereits erwähnt vorteilhaft, eine Vielzahl von Substratplatten mit eingesetzten Grünlingen auf einer Palette zu sammeln und diese in den Autoklaven zu verbringen. Hierin findet dann eine vorteilhafte Sammelsinterung statt.

Am Ende des Sinterprozesses liegt ein Halbzeug eines thermoelektrischen Bauelements vor, welches aus dem isolierenden Substrat mit darin eingebrachten Thermoschenkeln besteht. Um daraus einen funktionsfähigen thermoelektrischen Generator aufzubauen, ist es erforderlich, das in den Löchern versinterte Aktivmaterial zumindest auf einer Seite des Substrats elektrisch untereinander in geeigneter Weise zu kontaktieren, beispielsweise durch Löten. Durch das Zusammenlöten der einzelnen Thermoschenkel entstehen thermoelektrisch aktive Thermopaare. Darüber hinaus können eine Vielzahl von Thermopaaren innerhalb des thermoelektrischen Bauelements parallel und/oder seriell miteinander verschaltet werden, um die Leistung des TEG bzw. seine Spannung zu erhöhen. Das Verschalten der Thermoschenkel bzw. Thermopaare erfolgt vorzugsweise mittels bekannter Löttechnologie.

Allerdings ist beim Löten zu beachten, dass Bestandteile des Lotes wie beispielsweise Zinn, Silber oder Blei signifikant in die Aktivmaterialien eindiffundieren können, was die Leistungsfähigkeit des thermoelektrischen Bauelements nachhaltig beeinträchtigen kann. Um dies zu verhindern, sollte zwischen dem Aktivmaterial und dem Lot eine Diffusionsbarriere vorgesehen werden. Als Diffusionsbarriere eignet sich insbesondere eine Schicht aus Nickel, Wolfram, Molybdän oder Kohlenstoffmodifikation, allein oder Mischungen daraus. Eine solche Diffusionsbarriere kann beispielsweise durch Sputtern, Chemical Vapor Deposition oder durch Pulverplasmaspritzen aufgetragen werden. Im Zuge des erfindungsgemäßen Verfahrens ist es aber auch denkbar, die Diffusionsbarriere umformend aufzutragen:
Dieser Idee folgend wird die Matrize als Gesenk genutzt und auf die Matrize eine Folie aus Barrierematerial beispielsweise aus Nickel aufgelegt. Der Stempel fährt dann gegen die Folie und stanzt an der Schneidkante des Gesenks eine Scheibe aus der Folie aus und presst diese als Diffusionsbarriere auf das Aktivmaterial auf. Dieses kombinierte Press-/Stanzverfahren zum Aufbringen der Diffusionsbarriere auf den Grünlingen erfolgt denknotwendig vor dem Verpressen.

Das Aufbringen der Diffusionsbarriere mit Hilfe eines Beschichtungsverfahrens kann indes nach dem Eindrücken der Grünlinge in das Substrat erfolgen oder sogar erst nach dem Sintervorgang.

Das Zusammenlöten der Thermoschenkel zu Thermopaaren und gegebenenfalls das Verschalten der Thermopaare kann nach, aber auch bereits während des Sinterns erfolgen, da die Sintertemperaturen üblicherweise höher sind als die Schmelztemperaturen gebräuchlicher Lote.

Anstelle konventioneller Löttechnologie kann auch ein Flammspritz-Verfahren zur Kontaktierung der Thermopaare eingesetzt werden. Ein geeignetes Flammspritz-Verfahren ist aus WO02068245A1 bekannt. Ebenso kann thermisches Spritzen gemäß DIN32530 angewendet werden

### Figurenbeschreibung

Die vorliegende Erfindung soll nun anhand von Ausführungsbeispielen näher erläutert werden. Hierfür zeigen schematisch:

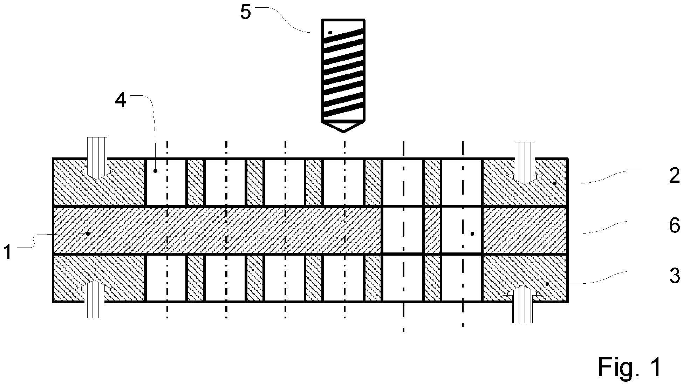

- Figur 1:: Durchbohren des Substrats;
- Figur 2:: Bereitstellen des pulverförmigen Aktivmaterials innerhalb der Form;
- Figur 3:: Verpressen des Pulvers zu Grünlingen;
- Figur 4:: Eindrücken der Grünlinge in die Löcher des Substrats;
- Figur 5:: Substrate mit Grünlingen im Autoklaven.

Ein im Wesentlichen ebenes Substrat 1 in Gestalt einer Platte aus einem elektrisch und thermisch isolierenden Substratmaterial wird zwischen zwei Spannmitteln 2, 3 eingelegt und dazwischen vollflächig eingespannt. Die Spannmittel 2, 3 sind aus Stahl und mit einer Vielzahl von Bohrungen 4 versehen, wobei die Bohrungen in dem oberen Spannmittel 2 mit denen im unteren Spannmittel 3 fluchten. Ein Bohrer 5 fährt durch die Bohrungen 4 in dem oberen Spannmittel 2 hinein und bohrt Durchgangslöcher 6 in das Substrat 1. Beim Bohren wird beidseitig über die Spannmittel 2, 3 eine Klemmkraft auf das Substrat 1 ausgeübt, um ein Ausbrechen der Löcher 6 zu verhindern.

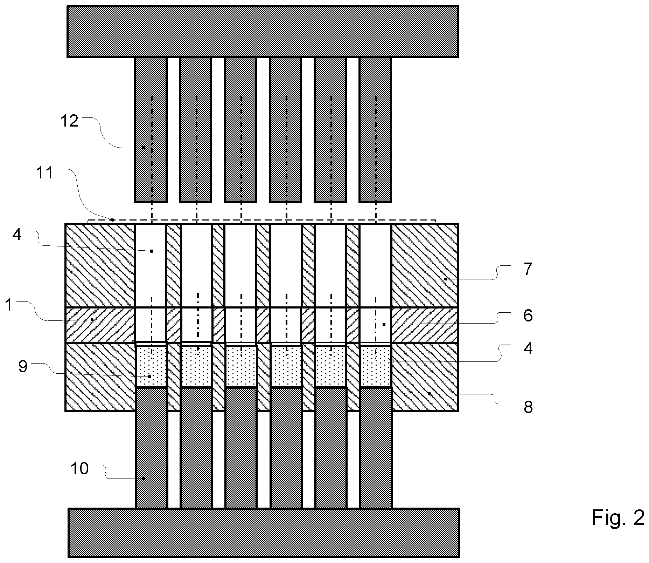

Sodann wird das gelochte Substrat 1 zwischen zwei Matrizen 7, 8 eingespannt, vgl. Figur 2. Die beiden Matrizen 7, 8 sind ebenfalls mit Bohrungen 4 versehen, die mit den Löchern 6 in dem Substrat 1 fluchten. Die Matrizen 7, 8 können identisch sein mit den Spannmitteln 2, 3, müssen es aber nicht. Die ebenen Matrizen 7, 8 sind aus Stahl gefertigt, liegen vollflächig auf dem Substrat 1 auf und üben eine Klemmkraft auf das Substrat 1 aus. Die Bohrungen 4 in der unteren Matrize 8 dienen als Form zur Aufnahme von pulverförmigem thermoelektrischem Aktivmaterial 9. Hierfür müssen die Bohrungen bodenseitig verschlossen werden. Dafür wird von unten jeweils ein unterer Stempel 10 in die Bohrungen 4 der unteren Matrize 8 eingefahren, sodass eine nur in Richtung des Substrats 1 geöffnete Kavität entsteht, welche von oben mit pulverförmigem Aktivmaterial 9 gefüllt wird. Es werden wechselseitig zwei Sorten

Aktivmaterial eingefüllt entsprechend den späteren n-Schenkeln und p-Schenkeln. In der Zeichnung wird hier nicht zwischen den beiden Sorten Aktivmaterial differenziert.

Auf die obere Matrize 7 kann zudem eine Folie 11 aus einem Barrierematerial wie Nickel aufgelegt werden. Eine Vielzahl obere Stempel 12 sind zu einem Presswerkzeug zusammengefasst.

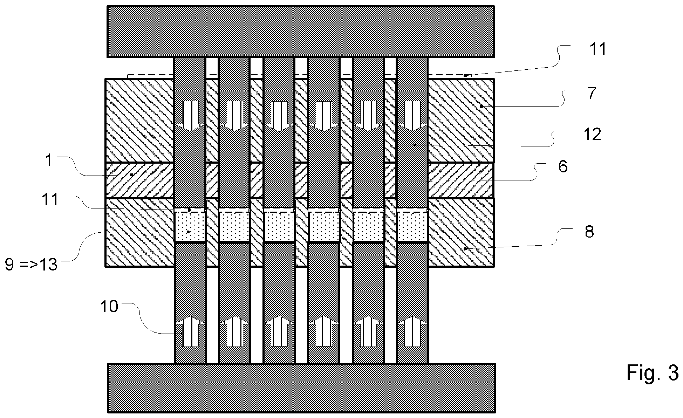

Wie in Figur 3 dargestellt, wird das Presswerkzeug mit den oberen Stempeln 12 herabgefahren, sodass die oberen Stempel 12 durch die obere Matrize 7 und die Löcher 6 in dem Substrat 1 hindurchgreifen. Beim Eintauchen in die obere Matrize 7 stanzen die oberen Stempel 12 an der Schneidkante der insoweit als Gesenk dienenden oberen Matrize 7 eine Ronde aus Barrierematerial aus der Folie 11 aus und drücken sie gegen das Aktivmaterial 9. In analoger Weise kann von unten eine Ronde aus Barrierematerial gegen das pulverförmige Material gepresst werden, um die Unterseite ebenfalls mit Barrierematerial abzudecken. Dies ist allerdings in den Zeichnungen nicht dargestellt.

Erforderlichenfalls kann das pulverförmige Aktivmaterial 9 innerhalb der unteren Matrize 8 mit Vibration beaufschlagt werden. Dies geschieht durch Vibrieren der unteren Matrize 8 oder der unteren Stempel 10 oder mittels einer in die Pulverschüttung von oben eintauchenden vibrierenden Nadel (nicht dargestellt). Durch die eingebrachte Vibration setzt sich das Aktivmaterial.

Innerhalb der unteren Matrize 8 wird das pulverförmige Aktivmaterial 9 nun zu Grünlingen 13 verpresst. Die dabei entstehenden Querkräfte werden von der unteren Matrize 8 aufgenommen. Das Verpressen erfolgt durch Beaufschlagung der Stempelpaare 10, 12 über die jeweiligen Presswerkzeuge.

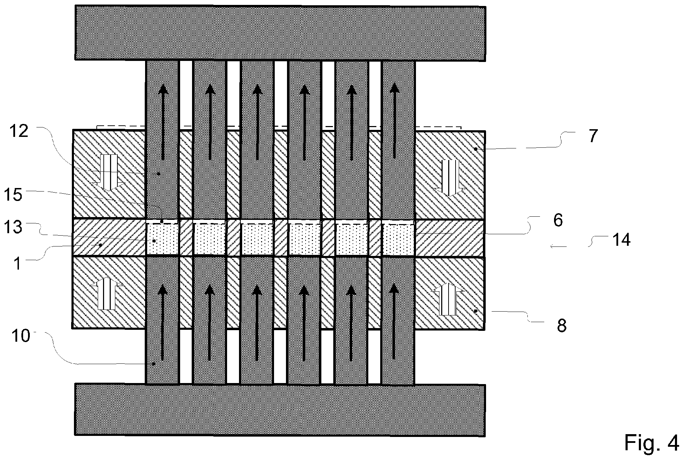

Sodann bewegen sich die Presswerkzeuge 10, 12 nach oben, sodass die unteren Stempel 10 die Grünlinge 13 in die Löcher 6 des Substrats 1 eindrücken (Figur 4). Der obere Stempel 12 weicht dabei mit derselben Geschwindigkeit zurück wie der untere Stempel 10 vorfährt, damit die Grünlinge 13 zerstörungsfrei in das Substrat 1 einfahren. Über die Matrizen 7, 8 wird dabei ein Druck auf das Substrat 1 ausgeübt.

Sobald die Grünlinge 13 an ihrem vorgesehenen Platz angekommen sind, fahren die Stempel 12 und 10 aus den Matrizen 7 und 8 aus, die Matrizen 7, 8 fahren auseinander und ein Halbzeug 14 umfassend das Substrat 1 mit den eingesetzten Grünlingen 13 und ggfs. den aufgesetzten Diffusionsbarrieren 15 entformt.

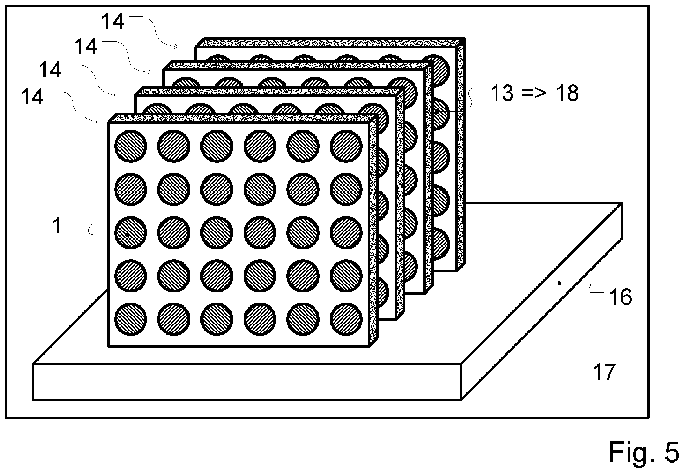

Der Fertigungsprozess wurde bis hierhin weitestgehend getaktet kontinuierlich geführt. Zur Sinterung der Grünlinge 13 werden diese auf einer Palette 16 gesammelt und in einen Autoklaven 17 verbracht; vgl. Figur 5. Darin werden die Halbzeuge 14 einem thermischen Sinterprozess unterworfen bei erhöhtem Atmosphärendruck und erhöhter Temperatur. Die Grünlinge 13 sintern dabei zu fertigen Thermoschenkeln 18.

Nach Abschluss des Sinterprozesses sind die einzelnen Thermoschenkel 18 noch zu Thermopaaren zu verschalten. Dies geschieht z.B. durch einen an sich bekannten Lötprozess, der hier nicht mehr dargestellt ist. Durch die Verschaltung der Thermoschenkel 18 zu Thermopaaren und ggf. der Thermopaare untereinander entsteht ein funktionsfähiges thermoelektrisches Bauelement.

### Beispiel

Zunächst müssen geeignete Halbleiterpulver (n- und p-dotiert) hergestellt werden. Als Ausgangmaterial liegen Ingots vor, deren Zusammensetzungen in Tabelle 1 wiedergegeben ist.

**Tabelle 1: Zusammensetzung der Ausgangsmaterialien**

| **Elemente** | **p-Typ wt %** | **n-Typ wt %** |
|---|---|---|
| **Sum Be..Fe** | 0,16 | - |
| **34+Se** | - | 2,64 |
| **51+Sb** | 26,88 | - |
| **52+Te** | 56,68 | 43,12 |
| **Sum La..Lu** | 0,12 | 0,27 |
| **83+Bi** | 16,38 | 54,23 |

Die Zusammensetzungen wurden mittels semi-RFA-Analysen ermittelt (max. relative Abweichungen +/-5%)

Der Mahlvorgang sieht dabei für alle o.g. Halbleitermaterialien wie folgt aus:
- Inertisierung: Alle Arbeiten unter Stickstoff (5.0) in Glovebox
- Mühle: Fritsch Pulverisette 6 classic line
- Mahlbecher: Zirkonoxid, gasdicht verschließbar
- Mahlkörper: 20 Kugeln (Durchmesser 2 cm) aus Zirkonoxid
- Drehzahl: 650 min-1
- Pulverfüllung: 225 cm³ (grob gebrochen, d50 < 5mm)
- Ablauf: 10 Mahlvorgänge je 10 min, dazwischen je 60min Pause zur Abkühlung (thermische Belastung des Mahlguts begrenzen)
- Analytik: Partikelgrößenverteilung mit HORIBA 920-L, Pulver mit Ultraschall dispergiert in demineralisiertem Wasser, max. Pumpen-Kreislaufrate
- Zielwert: d50 < 8 µm (ansonsten weitere Mahlgänge)

Aus Pamitherm® (Dicke 2mm) wird ein Quadrat von 51 mm Kantenlänge ausgesägt.

Dieses Substrat wird zwischen zwei Spannmitteln (Stahlblock 51x51x15mm) platziert und mit einer Anpresskraft von 20kPa zwischen diesen fixiert. Die Spannmittel weisen eine Vielzahl von Bohrungen mit Durchmesser 4,1 mm auf, mit minimalen Seitenabständen von 1,9mm zwischen je zwei Bohrungen. Die Bohrungen in beiden Spannmitteln sind jeweils identisch platziert und fluchten daher miteinander.

Durch alle Löcher des ersten Spannmittels wird nun je ein Bohrer geführt, welcher ein durchgängiges und zu den Löchern in beiden Spannmitteln fluchtendes Loch in das Substrat bohrt. Der Bohrer-Durchmesser ist 4mm, Vorschub 200mm/min, Drehzahl 1600/min, Bohrertyp: Vollhartmetallbohrer Fabrikat "Miller Mega-Drill-Inox, Schaftform HA, MxF-beschichtet, Typ M1703-0400AE".

Das so erhaltene Substrat wird zwischen zwei den erstgenannten ähnlichen Spannmitteln fixiert. Der einzige Unterschied zu den ersten Spannmitteln ist, dass hier die durchgehenden Bohrungen einen Nenndurchmesser von 4mm aufweisen, identisch zu den Löchern im Substrat.

Dieses Sandwich wird in einer zweiseitig wirkenden Hydraulikpresse fixiert. Diese Presse verfügt über zwei Hydraulikstempel mit Nenndurchmesser 4mm und Länge 30mm, welche auf der gleichen, senkrecht angeordneten Mittelachse liegen. Beide Stempel können unabhängig voneinander auf dieser Mittelachse verfahren werden, wobei sich die Stempelflächen gegenüber stehen. Der eine Stempel wirkt dabei von unten, während der andere von oben wirkt. Die beiden Stempel sowie die Bohrungen in den beiden Spannmitteln sind gemäß DIN 7157 mit einer Passung H7/g6 zueinander gefertigt (alternativ noch zulässig: H8/h9).

Der untere Stempel wird durch eine Bohrung des unteren Spannmittels nach oben geführt, bis seine Oberseite noch einen Abstand von 6mm zum Substrat hat.

Von oben wird nun in dieses Loch des oberen Spannmittels eine Menge von 0,186g des gemahlenen Wismuthtellurid-Pulvers (n-dotiert) eingefüllt. Von oben wird nun eine Schwingnadel in die Schüttung gesteckt (Durchmesser 0,5mm, Länge 100mm) und für 1 Sekunde in Schwingungen versetzt (Frequenz 100Hz, Amplitude an freier Nadelspitze 0,5mm). Dadurch setzt und homogenisiert sich die Pulverschüttung.

Der obere Stempel wird nun von oben in dieses Loch eingefahren (Vorschub 1 mm/s), bis zwischen den beiden Stempeln ein Grünling von 2mm Höhe (Toleranz +/-0,1 mm) erzeugt und ein Druck von ca. 830 MPa erreicht ist. Die Stempel verharren in dieser Stellung für 5 Sekunden.

Danach fahren beide Stempel mit einem Vorschub von 1 mm/s synchron richtungsentgegengesetzt derart, dass der Grünling aufwärts in das Substrat geschoben wird, wobei die Presskraft auf den Grünling im Wesentlichen aufrecht erhalten, keinesfalls aber weiter erhöht wird. Der Grünling liegt nun eingebettet im Substrat, seine Ober- und Unterseite sind weitgehend bündig mit den beiden Oberflächen des Substrates.

Beide Stempel ziehen sich nun aus dem Substrat und den Spannmitteln vollständig zurück.

In analoger Weise werden nun alle weiteren n-Schenkel im Substrat erzeugt (Hälfte aller Bohrungen im Substrat). Danach wird der gleiche Vorgang für die p-Schenkel wiederholt, so dass am Ende alle Bohrungen im Substrat mit Grünlingen aus n- bzw-p-dotiertem Wismuthtellurid gefüllt sind. Einzige Unterschiede bei den p-Schenkeln sind die Pulvereinwaage pro Grünling (0,162g) sowie die maximale Presskraft (ca. 800 MPa).

Das gefüllte Substrat wird nun in eine Glovebox, gespült mit Stickstoff 5.0 und einem Restsauerstoffgehalt von <100ppm, verbracht. In dieser Glovebox befindet sich ein Autoklav, welcher auf eine Oberflächentemperatur der Innenwand von 290°C vorgeheizt ist. In diesen Autoklaven wird nun das gefüllte Substrat eingebracht. Der Innenraum des Autoklaven wird ebenfalls mit Stickstoff 5.0 gespült (mindestens 20 komplette Gaswechsel pro Stunde). Nun wird der Druck im Autoklaven innerhalb von 2 Minuten auf 90bar=9 MPa erhöht, danach steigt die Gastemperatur im Inneren des Autoklaven innerhalb von weiteren ca. 3 Minuten auf 285-290°C. Dieser Druck und diese Temperatur werden für 5 Minuten gehalten. Danach wird der Druck innerhalb 1 Minute bis auf Normaldruck abgesenkt, das nunmehr gesinterte Halbzeug entnommen und zum Abkühlen auf Raumtemperatur in der Glovebox belassen.

Hernach können die weiteren zur Vervollständigung eines TE-Bauelementes notwendigen Arbeitsschritte an dem gesinterten Halbzeug vorgenommen werden:
- Reinigung der Stirnflächen der TE-Schenkel (Polieren, Plasma-Behandlung o.ä.)
- Aufbringung von Diffusionsbarrieren (z.B. Nickel mittels Atmosphärendruck-Plasmabeschichtung)
- Aufbringung von Kontaktierungshilfsschichten (z.B. Zinn mittels Atmosphärendruck-Plasmabeschichtung)
- Verlötung mit Kontaktbrücken
- Aufbringung von Hüllschichten

### Bezugszeichenliste

- 1: Substrat
- 2: oberes Spannmittel
- 3: unteres Spannmittel
- 4: Bohrungen
- 5: Bohrer
- 6: Loch
- 7: obere Matrize
- 8: untere Matrize
- 9: pulverförmiges Aktivmaterial
- 10: untere Stempel
- 11: Folie
- 12: obere Stempel
- 13: Grünling
- 14: Halbzeug
- 15: Diffusionsbarriere
- 16: Palette
- 17: Autoklav
- 18: Thermoschenkel

## Patentansprüche

1. Verfahren zur Herstellung eines thermoelektrischen Bauelements oder zumindest eines Halbzeugs desselben, bei welchem in ein im Wesentlichen ebenes Substrat aus einem elektrisch und thermisch isolierenden Substratmaterial eine Vielzahl von Thermoschenkeln aus thermoelektrisch aktivem Aktivmaterial dergestalt eingebracht wird, dass sich die Thermoschenkel im Wesentlichen senkrecht zur Substratebene durch das Substrat hindurch erstrecken, und bei welchem das Aktivmaterial pulverförmig bereitgestellt, zu Grünlingen verpresst und anschließend innerhalb des Substrats zu Thermoschenkeln versintert wird, **dadurch gekennzeichnet, dass**
das pulverförmige Aktivmaterial in einer außerhalb des Substrats angeordneten Form zu Grünlingen verpresst wird, die Grünlinge aus der Form heraus in vorgesehene Löcher des Substrats eingedrückt und darin zu Thermoschenkeln versintert werden, wobei
das Verpressen des pulverförmigen Aktivmaterials zu Grünlingen und das Eindrücken der Grünlinge in die Löcher des Substrats mit Hilfe derselben Werkzeuge erfolgen und wobei es sich bei den Werkzeugen um mindestens ein Paar beidseitig in die Form einfahrende Stempel handelt, von denen einer durch das für den jeweiligen Grünling im Substrat vorgesehene Loch hindurch greift.

2. Verfahren nach Anspruch 1,
**dadurch gekennzeichnet,**
**dass** eine Mehrzahl von Formen zu einer ebenen Matrize zusammengefasst sind, und dass die Matrize zumindest während des Verpressens des Aktivmaterials und des Eindrückens der Grünlinge auf dem Substrat dergestalt flächig aufliegt, dass Löcher und Formen fluchten.

3. Verfahren nach einem der vorhergehenden Ansprüche,
**dadurch gekennzeichnet,**
**dass** Löcher und Form kreiszylindrisch sind und im Wesentlichen denselben Durchmesser aufweisen.

4. Verfahren nach einem der vorhergehenden Ansprüche,
**dadurch gekennzeichnet,**
**dass** die Löcher spanend in das Substrat eingebracht werden, insbesondere durch Bohren und ohne Zuhilfenahme von Kühlschmierstoffen.

5. Verfahren nach Anspruch 4,
**dadurch gekennzeichnet,**
**dass** die Löcher nach der spanenden Bearbeitung ausgeblasen werden, insbesondere mit einem inerten Gas.

6. Verfahren nach Anspruch 4 oder 5,
**dadurch gekennzeichnet,**
**dass** das Substrat während des Einbringens der Löcher beidseitig von ebenen Spannmitteln gehalten wird, insbesondere vollflächig.

7. Verfahren nach Anspruch 2 und 6,
**dadurch gekennzeichnet,**
**dass** eines der beiden Spannmittel nach Einbringen der Löcher als Matrize genutzt wird.

8. Verfahren nach einem der vorhergehenden Ansprüche,
**dadurch gekennzeichnet,**
**dass** es sich bei dem Substratmaterial um einen Verbundwerkstoff aus anorganischen Rohstoffen und Bindemitteln handelt.

9. Verfahren nach Anspruch 8,
**dadurch gekennzeichnet,**
**dass** der Verbundwerkstoff als Laminat aufgebaut ist, dass die organische Rohstoffe ausgewählt sind aus der Gruppe umfassend Glimmer, Perlite, Phlogopite, Muscovite, und dass es sich bei dem Bindemittel um Silikon oder um Silikonharz handelt.

10. Verfahren nach Anspruch 8 oder 9,
**dadurch gekennzeichnet,**
**dass** die Stärke des Substrats zwischen 1 und 10 mm beträgt; bevorzugt, dass sie zwischen 1.5 bis 4 mm beträgt und ganz besonders bevorzugt, dass die Stärke zwischen 2 und 3 mm beträgt.

11. Verfahren nach einem der vorhergehenden Ansprüche,
**dadurch gekennzeichnet,**
**dass** es sich bei dem Aktivmaterial um eine Legierung handelt, die ausgewählt ist aus der Klasse der Wismuthtelluride, Zinkantimonide, Silizide, Halb-Heusler-Materialien, und dass die mittels Laserbeugungsverfahren bestimmte Partikelgrößenverteilung des Aktivmaterials eine mittlere Partikelgröße d₅₀ zwischen 1 und 50 µm aufweist, und dass das Aktivmaterial zur Einstellung dieser Partikelgrößenverteilung bei einer maximalen Temperatur zwischen 30°C und 50°C vermahlen wurde.

12. Verfahren nach einem der vorhergehenden Ansprüche,
**dadurch gekennzeichnet,**
**dass** das pulverförmige Aktivmaterial vor dem Verpressen innerhalb der Form mit Vibration beaufschlagt wird.

13. Verfahren nach einem der vorhergehenden Ansprüche,
**dadurch gekennzeichnet,**
**dass** das Substrat mit eingebrachten Grünlingen zum Versintern in einen Autoklaven verbracht wird, in welchem der Sinterprozess bei erhöhtem Druck und erhöhter Temperatur in inerter Atmosphäre erfolgt, wobei insbesondere der Gasdruck innerhalb des Autoklaven geringer ist als der Druck, der beim Pressen der Grünlinge auf das pulverförmige Aktivmaterial ausgeübt.

## Claims

1. Method for producing a thermoelectric component or at least one semi-finished product of same, in which a multiplicity of thermolegs made of a thermoelectrically active active material are introduced into an essentially planar substrate made of an electrically and thermally insulating substrate material such that the thermolegs extend through the substrate essentially perpendicular to the substrate plane, and in which the active material is provided in pulverulent form, is pressed to give green bodies and is then sintered within the substrate to give thermolegs,
**characterized in that**
the pulverulent active material is pressed, in a mould arranged outside the substrate, to give green bodies, the green bodies are pushed out of the mould and into holes provided in the substrate, where they are sintered to give thermolegs, wherein
pressing the pulverulent active material to give green bodies and pushing the green bodies into the holes in the substrate is performed with the aid of the same tools and wherein the tools are at least one pair of punches which are inserted from both sides into the mould and of which one engages through the hole provided in the substrate for the respective green body.

2. Method according to Claim 1,
**characterized in that**
a plurality of moulds are combined to give a planar template, and **in that**, at least during pressing of the active material and insertion of the green bodies, the template lies areally on the substrate such that holes and moulds are in line with each other.

3. Method according to either of the preceding claims,
**characterized in that**
the holes and the mould are of circular cylindrical shape and have essentially the same diameter.

4. Method according to any of the preceding claims,
**characterized in that**
the holes are introduced into the substrate in a chip-removing manner, in particular by drilling and without the aid of cooling lubricants.

5. Method according to Claim 4,
**characterized in that**
the holes are blown clean after chip-removing machining, in particular using an inert gas.

6. Method according to Claim 4 or 5,
**characterized in that**
the substrate is held on both sides, in particular areally, by planar clamping means during introduction of the holes.

7. Method according to Claims 2 and 6,
**characterized in that**
one of the two clamping means is used as a template after introduction of the holes.

8. Method according to any of the preceding claims,
**characterized in that**
the substrate material is a composite material made of inorganic raw materials and binders.

9. Method according to Claim 8,
**characterized in that**
the composite material is constructed as a laminate, **in that** the organic raw materials are selected from the group comprising mica, perlite, phlogopite, muscovite and **in that** the binders are silicone or silicone resin.

10. Method according to Claim 8 or 9,
**characterized in that**
the thickness of the substrate is between 1 and 10 mm, preferably that it is between 1.5 and 4 mm and very preferably that the thickness is between 2 and 3 mm.

11. Method according to any of the preceding claims,
**characterized in that**
the active material is an alloy which is chosen from the class of bismuth tellurides, zinc antimonides, silicides, semi-Heusler materials, and **in that** the particle size distribution - determined by means of laser diffraction methods - of the active material has an average particle size d₅₀ of between 1 and 50 µm, and **in that**, to set this particle size distribution, the active material is ground at a maximum temperature of between 30°C and 50°C.

12. Method according to any of the preceding claims,
**characterized in that**
the pulverulent active material is acted upon with vibration within the mould prior to pressing.

13. Method according to any of the preceding claims,
**characterized in that**
the substrate, with introduced green bodies, is placed for sintering into an autoclave in which the sintering process takes place at elevated pressure and elevated temperature in an inert atmosphere, wherein in particular the gas pressure within the autoclave is lower than the pressure exerted on the pulverulent active material during pressing of the green bodies.

## Revendications

1. Procédé destiné à la fabrication d'un composant thermoélectrique ou tout au moins d'un produit semi-fini d'un tel composant, pour lequel une pluralité de branches thermiques, lesquelles sont constituées d'une matière active thermo-électriquement active, sont introduites dans un substrat, pour l'essentiel, plan, lequel est constitué d'une matière de substrat électriquement et thermiquement isolante, de telle sorte que les branches thermiques s'étendent à travers le substrat, pour l'essentiel, à la perpendiculaire par rapport au plan du substrat, et pour lequel la matière active est mise à disposition sous forme de poudre, compactée en des comprimés, puis ensuite frittée à l'intérieur du substrat pour donner lieu à des branches thermiques,
**caractérisé en ce que**
la matière active sous forme de poudre est compactée en comprimés dans un moule disposé à l'extérieur du substrat, les comprimés sont compressés en dehors du moule dans des trous du substrat prévus à cet effet et sont frittés à l'intérieur de ces trous pour donner lieu à des branches thermiques ;
selon lequel le compactage en comprimés de la matière active sous forme de poudre et la compression des comprimés dans les trous du substrat sont réalisés à l'aide des mêmes outils ; et
selon lequel les outils en question sont au moins une paire d'empreintes qui pénètre dans le moule par les deux côtés, dont l'une des empreintes passe à travers le trou prévu dans le substrat pour le comprimé respectif.

2. Procédé selon la revendication 1,
**caractérisé en ce que**
une majorité des moules sont regroupés en une matrice plane ; et **caractérisé en ce que** la matrice vient prendre appui à plat, tout au moins pendant le compactage de la matière active et pendant la compression des comprimés sur le substrat, de telle sorte que les trous et les moules sont alignés.

3. Procédé selon l'une des revendications précédentes,
**caractérisé en ce que**,
les trous et les moules sont en forme de cylindre circulaire et présentent, pour l'essentiel, le même diamètre.

4. Procédé selon l'une des revendications précédentes,
**caractérisé en ce que**,
les trous sont mis en place dans le substrat par un processus par enlèvement de copeaux, en particulier par forage et sans le recours à des liquides de refroidissement.

5. Procédé selon la revendication 4,
**caractérisé en ce que**,
les trous sont soumis à un flux d'air à l'issue de l'usinage par enlèvement de copeaux, en particulier au moyen d'un gaz inerte.

6. Procédé selon la revendication 4 ou 5,
**caractérisé en ce que**,
le substrat est maintenu par des moyens de serrage plans des deux côtés, pendant la mise en place des trous, en particulier sur toute la surface.

7. Procédé selon les revendications 2 et 6,
**caractérisé en ce que**,
l'un des deux moyens de serrage est utilisé comme une matrice après la mise en place des trous.

8. Procédé selon l'une des revendications précédentes,
**caractérisé en ce que**,
la matière du substrat en question est une matière composite constituée de matières premières anorganiques et d'agents de liaison.

9. Procédé selon la revendication 8,
**caractérisé en ce que**,
la matière composite est structurée sous la forme d'un stratifié ; **caractérisé en ce que** les matières premières organiques sont sélectionnées à partir du groupe constitué par le mica, la perlite, la phlogopite, la muscovite ; et **caractérisé en ce que** l'agent de liaison en question est de la silicone ou une résine de silicone.

10. Procédé selon la revendication 8 ou 9,
**caractérisé en ce que**,
l'épaisseur du substrat est comprise entre 1 mm et 10 mm ; **caractérisé en ce que** l'épaisseur du substrat est comprise, de manière préférée, entre 1,5 mm et 4 mm ; et **caractérisé en ce que** l'épaisseur du substrat est comprise, de manière tout particulièrement préférée, entre 2 mm et 3 mm.

11. Procédé selon l'une des revendications précédentes,
**caractérisé en ce que**,
la matière active en question est un alliage qui est sélectionné à partir de la catégorie constituée par le tellurure de bismuth, l'antimoniure de zinc, le siliciure, les matières de type semi-Heusler ; et **caractérisé en ce que** la répartition dimensionnelle des particules de la matière active, déterminée au moyen de la méthode de diffraction au laser, présente une taille moyenne de particules d₅₀ comprise entre 1 µm et 50 µm ; et **caractérisé en ce que** la matière active destinée à l'ajustement de cette répartition dimensionnelle des particules a été moulue à une température maximale comprise entre 30 °C et 50 °C.

12. Procédé selon l'une des revendications précédentes,
**caractérisé en ce que**,
la matière active sous forme de poudre est soumise, avant le compactage, à des vibrations à l'intérieur du moule.

13. Procédé selon l'une des revendications précédentes,
**caractérisé en ce que**,
le substrat, avec les comprimés mis en place, est placé dans un autoclave en vue du frittage, à l'intérieur duquel le processus de frittage a lieu dans une atmosphère inerte, à une pression élevée et à une température élevée ; selon lequel, en particulier, la pression du gaz à l'intérieur de l'autoclave est inférieure à la pression qui est exercée durant le compactage des comprimés sur la matière active sous forme de poudre.
